# EUROPEAN PATENT APPLICATION

(11) **EP 3 961 705 A1**
(43) Date of publication of application: **02.03.2022**
(21) Application number: 20193561.6
(22) Date of filing: 31.08.2020
(51) Int. Cl.: H01L 25/075, H01L 33/64, H01L 33/62

(54) **MULTI-COLOR LIGHTING DEVICE**

(71) Applicant: Lumileds LLC, San Jose, CA 95131 (US)
(72) Inventor: The designation of the inventor has not yet been filed
(74) Representative: ter Heegde, Paul Gerard Michel

(57) **Abstract**

According to the invention a lighting device (100) is provided comprising an electrically insulating layer (103); at least one first light emitting element (111) configured to emit light of a first color, and at least one second light emitting element (113) configured to emit light of a second color, the at least one first light emitting element and the at least one second light emitting element being arranged on the electrically insulating layer; and at least one electrical contact element (121, 123, 125), wherein the at least one electrical contact element is arranged at least in part on the electrically insulating layer and is electrically connected to the at least one first light emitting element and/or to the at least one second light emitting element.

## Description

### FIELD OF THE INVENTION

The present disclosure relates to a lighting device, in particular a light-emitting diode (LED) based lighting device, to an automotive lighting system, and to a method for producing a lighting device.

### BACKGROUND OF THE INVENTION

Lighting devices based on Light Emitting Diodes (LEDs) are advantageous in terms of light output and energy efficiency and are therefore welcome replacements of conventional light sources like filament lamps in automotive applications. Thereby, a provision of such lighting devices faces challenges in particular in placement accuracy of light sources with respect to complementary optical systems (such as reflectors or light guides) and thermal management. In addition, LED based automotive lighting systems such as daytime running lights or turn signal lights often rely on customized and complex solutions hampering their provision by mass-production.

### SUMMARY OF THE INVENTION

It is thus an object of the present invention to provide a lighting device that allows for an improved thermal management, that allows to be used with existing complementary optical systems and that supports reducing complexity of the overall system. It is a further object of the present invention to provide a corresponding automotive lighting system and a method for producing a lighting device.

According to a first aspect of the present invention, a lighting device is provided, the lighting device comprising an electrically insulating layer; at least one first light emitting element configured to emit light of a first color, and at least one second light emitting element configured to emit light of a second color, the at least one first light emitting element and the at least one second light emitting element being arranged on the electrically insulating layer; and at least one electrical contact element, wherein the at least one electrical contact element is arranged at least in part on the electrically insulating layer and is electrically connected to the at least one first light emitting element and/or to the at least one second light emitting element.

According to a second aspect of the present invention, an automotive lighting system, in particular headlight, comprising the lighting device according to the first aspect is provided.

According to a third aspect of the present invention, a method for producing a lighting device, in particular according to the first aspect, is provided, the method comprising: providing an electrically insulating layer; providing at least one first light emitting element configured to emit light of a first color, and at least one second light emitting element configured to emit light of a second color, the at least one first light emitting element and the at least one second light emitting element being arranged on the electrically insulating layer; and providing at least one electrical contact element; wherein the at least one electrical contact element is arranged at least in part on the electrically insulating layer and is electrically connected to the at least one first light emitting element and/or to the at least one second light emitting element.

Exemplary embodiments of the first, the second and the third aspect of the invention may have one or more of the properties described below.

By providing the at least one first light emitting element and the at least one second light emitting element arranged on the electrically insulating layer, a compact and stable construction can be achieved. In other words, the electrically insulating layer serves as a support structure for the at least one first light emitting element and/or for the at least one second light emitting element and may thus be seen as backbone of the lighting device.

While the electrically insulating layer may be formed of any suitable material, e.g. a suitable plastic material, it turned out that ceramic materials are of particular advantage. In an exemplary embodiment, the electrically insulating layer comprises or consists of a ceramic material and/or a material with a thermal conductivity of more than 10 W/(m*K), in particular more than 100 W/(m^{∗}K). In a particular exemplary embodiment, the electrically insulating layer comprises or consists of aluminum nitride (AlN). In this way, suitable mechanical stiffness and reliability can be achieved using a material with high thermal conductivity. It is noted that, in an exemplary embodiment, the electrically insulating layer and/or the lighting device does not comprise an Insulated Metal Substrate (IMS).

In an exemplary embodiment, the lighting device further comprises an interface layer, the electrically insulating layer being arranged on the interface layer. Thus, by providing the at least one first light emitting element and the at least one second light emitting element arranged on the electrically insulating layer, which in turn is arranged on the interface layer, a path is provided for directing heat generated by the light emitting elements away via the interface layer. In other words, the specific arrangement of these components advantageously enables a beneficial heat management. In order to facilitate an advantageous heat transport, in an exemplary embodiment, the interface layer is thermally conductive. For example, a thermal conductivity of the interface layer is in an exemplary embodiment larger than 100 W/(m^{∗}K). Suitable thermal conductivity can be achieved by appropriately selecting a material of or comprised by the interface layer. In other words, in an exemplary embodiment, the interface layer comprises or consists of metal, in particular aluminum (Al), copper (Cu) and/or gold (Au). In a particular exemplary embodiment, the interface layer comprises or consists of gold-coated copper.

In an exemplary embodiment, the interface layer is in direct mechanical contact with the electrically insulating layer. In this way, a thermal coupling between the interface layer and the electrically insulating layer is achieved which enables an improved thermal management of the lighting device as heat generated by the at least one first and the at least one second light emitting element arranged on the insulating layer is advantageously guided away via the interface layer. In an exemplary embodiment, a thickness of the electrically insulating layer is less than or equal to 0.5 mm, in particular 0.4 mm, in particular 0.3 mm. Such a thin electrically insulating layer is particularly beneficial for an improved heat transport through the electrically insulating layer. Advantageously enabling this effect, in an exemplary embodiment, the interface layer corresponds to or comprises a plate or substrate which allows an improved coupling between this structure and the electrically insulating layer. In an exemplary embodiment, the interface layer is further coupled with a heatsink for further guiding heat away from the lighting device.

In an exemplary embodiment, the at least one first light emitting element and/or the at least one second light emitting element corresponds to or comprises a light emitting diode (LED). In an exemplary embodiment, the at least one first light emitting element and/or the at least one second light emitting element corresponds to or comprises one or more LED dies. In other words, while the light emitting elements may comprise further components, the light emitted by the light emitting elements is, in an exemplary embodiment, generated by LEDs. LEDs are in particular advantageous in terms of energy efficiency and in that LEDs allow for realizing different shapes and colors in accordance with desired applications.

As mentioned, the at least one first light emitting element and the at least one second light emitting element are configured to emit light of a first and a second color, respectively. According to a first option, in an exemplary embodiment, at least one of the at least one first and the at least one second light emitting element further comprises a respective phosphor layer arranged on a corresponding light output surface of the respective at least one of the at least one first light emitting element and the at least one second light emitting element. By appropriately selecting a phosphor coating, a color of light emitted from a corresponding light emitting element may be suitably adjusted. Alternatively or additionally, in an exemplary embodiment, at least one of the at least one first and the at least one second light emitting element is configured as a light emitting element for directly emitting light of the first and/or the second color.

In an exemplary embodiment, the at least one first light emitting element and the at least one second light emitting element are arranged on and in direct mechanical contact with the electrically insulating layer. Thus, the at least one first light emitting element and the at least one second light emitting element are in direct thermal coupling with the electrically insulating layer such that heat generated by the light emitting elements can be efficiently dissipated away by the described combined effect of the electrically insulating layer and the interface layer.

In an exemplary embodiment, the at least one electrical contact element is arranged on, in particular in direct mechanical contact with, the electrically insulating layer, and is configured for electrically connecting the at least one first light emitting element and/or the at least one second light emitting element to a power source. Placing the at least one electrical contact element on top of the electrically insulating layer instead of contacting the lighting device from e.g. its bottom side, advantageously enables use of a large, in particular metallic, thermal pad as interface layer, thus reducing the thermal resistance of the lighting device.

In other words, by placing the at least one electrical contact element on the top side of the lighting device, space is provided for use of a large thermal pad provided at a bottom side of the lighting device which otherwise would be partially covered by electrical contacts. Thus, in an exemplary embodiment, the interface layer corresponds to or comprises a thermal pad, in particular a thermal pad comprising or consisting of a metal. In an exemplary embodiment, the thermal pad covers essentially an entire bottom face of the lighting device, in particular wherein the bottom face is opposite of a face of the lighting device at which the at least one first and the at least one second light emitting elements are arranged.

In an exemplary embodiment, the first color is different from the second color, wherein the first and/or the second color are selected from: a white color; an amber color; a cyan color.

In an exemplary embodiment, the first color is a white color, the at least one first light emitting element thus being configured to emit white light. In an exemplary embodiment, light of the white color is light comprising a superposition of at least two, in particular more than two, optical wavelength spectra (e.g. spectral colors). For example, a white color may be realized by a light emitting diode configured for emitting light of blue color provided with a phosphor coating that converts part of the blue light into yellow light, the mixture of blue and yellow light generating a white appearance. Different white colors may be characterized by a respective color temperature. Thereby, in an exemplary embodiment, the first color is a white color having a correlated color temperature, CCT, in between 4000K and 6700K.

In an exemplary embodiment, the first and/or second color is a cyan color, i.e. a color in between blue and green, the at least one first and/or second light emitting element thus being respectively configured to emit light of a cyan color. In an exemplary embodiment, light of a cyan color can be characterized by a spectrum of optical wavelengths with a dominant wavelength between 490 nm and 510 nm.

In an exemplary embodiment, the second color may be chosen from a red/magenta, green, blue/cyan, orange and/or yellow color or any combination thereof. Thus, in an exemplary embodiment, the at least one second light emitting element is configured to emit red/magenta, green, blue/cyan, orange, yellow and/or amber light.

In an exemplary embodiment, the second color is an amber color, e.g. in between yellow and orange, the at least one second light emitting element thus being configured to emit light of an amber color. In an exemplary embodiment, light of an amber color can be characterized by a spectrum of optical wavelengths with a dominant wavelength between 585 nm and 600 nm.

In a particular exemplary embodiment, the at least one second light emitting element is a light emitting diode, LED, provided with a suitable phosphor coating and thus configured to emit light of amber color, in particular light with a spectrum of optical wavelength with a dominant wavelength between 585 nm and 600 nm.

Realizing light emission of two different colors with the same lighting device offers the particular advantage that a plurality of desired functions can be realized with a single lighting device. In other words, in an exemplary embodiment, a white light generated by the lighting device may be used to allow for an illumination function, a cyan light may be used to allow for an autonomous driving mode, and an amber light may be used to allow for a signaling function. This allows for sharing electrical connection and heat management by at least two light emitting elements, thus advantageously enabling a lighting device architecture offering reduced complexity. For example, being configured for white or cyan light emission, the at least one first light emitting element is in particular suitable to be employed in a daytime running light mode or an autonomous driving mode, while the at least one second light emitting element, being configured for amber or cyan light emission, is in particular suitable to be employed in a turn signal mode or an autonomous driving mode.

In an exemplary embodiment, the interface layer is an interface plate, in particular comprising or essentially consisting of a metal. In an exemplary embodiment, the metal has a thermal conductivity of equal to or more than 100 W/(m^{∗}K), in particular more than 300 W/(m^{∗}K).

In an exemplary embodiment, the electrically insulating layer is in direct mechanical contact with the interface plate. As mentioned, direct mechanical contact between the electrical insulating layer and the interface layer enables advantageous thermal coupling of these components and in turn allows for heat generated by the at least one first and the at least one second light emitting element to be advantageously guided away.

In an exemplary embodiment, the lighting device, in particular the electrically insulating layer, comprises a connection portion for electrically connecting the lighting device and a mounting portion for mounting the at least one first light emitting element and the at least one second light emitting element, wherein a thickness of the connection portion is smaller than a thickness of the mounting portion. Thereby, the connection portion comprises respective portions of the interface layer and the electrically insulating layer and at least one electrical contact element. The different thickness of connection portion and mounting portion advantageously allow for electrically connecting the at least one electrical contact element to a power supply without hampering light emission and/or propagation, i.e. without having electrical contact means, e.g. bonding wires, blocking an optical path of light emitted by the at least one first light emitting element and the at least one second light emitting element. In an exemplary embodiment, the mounting portion comprises respective portions of the interface layer and the electrically insulating layer. In an exemplary embodiment, the portions of the interface layer and the electrically insulating layer comprised by the connection portion are different from the portions of the interface layer and the electrically insulating layer comprised by the mounting portion. In an exemplary embodiment, the at least one first light emitting element and the at least one second light emitting element are at least in part received inside of at least one corresponding portion of the mounting portion. The mounting portion thus supports a secure mechanically adjustment of respective positions of the light emitting elements with respect to the lighting device which enables a precise placement of the light emitting elements with respect to corresponding (external) optical systems. Further, being at least partially received by or embedded within the mounting portion, corresponding enhanced contact surfaces advantageously contribute to a beneficial heat transport by the mounting portion away from the light emitting elements.

In an exemplary embodiment, the mounting portion and the connection portion are arranged mutually adjacent forming a step at a transition from the connection portion to the mounting portion. Thereby, a step may to be understood as a bump and/or notch, wherein in an exemplary embodiment a height of the lighting device within the connection portion is smaller than a height of the lighting device within the mounting portion. The step may form a surface perpendicular to the upper surface of the lighting device.

In an exemplary embodiment, a height of the step corresponds to at least 10% of a maximum thickness of the lighting device, in particular to at least 20% of a maximum thickness of the lighting device, in particular to at least 40% of a maximum thickness of the lighting device.

It has been found that a lighting device comprising a step as described above advantageously allows for a less complex manufacturing process while protecting the at least one first and/or at least one second light emitting element against environmental conditions such as dust or humidity.

In an exemplary embodiment, the at least one first light emitting element and the at least one second light emitting element are respectively received at least in part inside of the mounting portion. The mounting portion thus supports a secure mechanical adjustment of respective positions of the light emitting elements with respect to the lighting device which enables a precise placement of the light emitting elements with respect to corresponding (external) optical systems. Further, being at least partially received by or embedded within the mounting portion, corresponding enhanced contact surfaces advantageously contribute to a beneficial heat transport by the mounting portion away from the light emitting elements.

In an exemplary embodiment, the at least one electrical contact element comprises an essentially planar contact portion and is arranged on the electrically insulating layer within the connection portion. Thereby, essentially planar may be understood such that in an exemplary embodiment, a height of the essentially planar contact portion is significantly smaller than a length and/or width of the essentially planar contact portion. In an exemplary embodiment, the height of the essentially planar contact portion amounts to less than or equal to 10% of the length and/or width of the essentially planar contact portion, in particular less than or equal to 5%.

In an exemplary embodiment, the essentially planar contact portion is arranged essentially parallel to a bottom surface of the lighting device and/or to respective light emitting surfaces of the at least one first light emitting element and/or the at least one second light emitting element. Being arranged essentially parallel may be understood such that in an exemplary embodiment, an angle formed by the essentially planar contact portion and respective light emitting surfaces is smaller than 10°, in particular smaller than 5°, in particular smaller than 3°. Arranging the essentially planar contact portion essentially parallel to a bottom surface of the lighting device and/or to respective light emitting surfaces advantageously results in a uniform shape of the lighting device, thereby offering reduced complexity in terms of an overall shape of the lighting device and simplifying the electrical connection of the lighting device.

In an exemplary embodiment, the at least one essentially planar electrical contact element corresponds to or comprises at least one contact pad and/or bond pad. Using essentially planar electrical contact elements turned out to be advantageous as it in particular supports enhancing robustness of the lighting device and contributes to achieving a particularly reliable electrical connection. Using such contacts elements may avoid for example that portions of the contact element stick out and helps to provide the lighting device less prone to damage e.g. during manufacturing and/or upon mounting.

In an exemplary embodiment, the at least one electrical contact element is located on a topside of the lighting device, wherein the topside of the lighting device corresponds to a light emitting side of the lighting device. In other words, in an exemplary embodiment, the at least one electrical contact element is configured for being electrically contacted from the top. Such an architecture allows for a large, in particular metallic, interface layer at the bottom side of the lighting device, thereby advantageously reducing the overall thermal resistance of the lighting device and thus allowing for an improved heat management.

In an exemplary embodiment, the at least one first light emitting element and the at least one second light emitting element are arranged adjacent to each other, such that respective light emission surfaces of the at least one first and the at least one second light emitting element are arranged in a common plane. Being arranged adjacent, the at least one first light emitting element and the at least one second light emitting element are mutually arranged in close proximity, e.g. in direct contact or with only a thin gap provided in between the at least one first light emitting element and the at least one second light emitting element. In an exemplary embodiment, the gap between the at least one first light emitting element and the at least one second light emitting element has a width equal to or less than 25% of a width of the at least one first light emitting element and/or of the at least one second light emitting element, in particular less than 10%, in particular less than 5%. It is noted that the gap may be filled with air or a different material.

In an exemplary embodiment, the lighting device comprises at least three electrical contact elements, two of which are respectively electrically connected with a corresponding one of the at least one first and the at least one second light emitting element, and wherein one of the at least three electrical contact elements is electrically connected to both of the at least one first light emitting element and the at least one second light emitting element.

In a further exemplary embodiment, the lighting device comprises at least a first, a second, a third and a fourth electrical contact element, wherein the at least one first light emitting element is electrically connected to the first and the second contact element, and wherein the at least one second light emitting element is electrically connected to the third and the fourth contact element.

Three or more electrical contact elements advantageously enable independently contacting the at least one first light emitting element and the at least one second light emitting element. In an exemplary embodiment, the electrical contact elements serve as anode and/or cathode for the at least one first light emitting element and/or for the at least one second light emitting element, respectively. Independently contacting the light emitting elements advantageously enables independently turning the light emitting elements ON or OFF and thus enables use of the light emitting elements in accordance with one or more predetermined modes of operation. Thereby, a mode of operation may e.g. correspond to a daytime running light mode, an autonomous driving mode and/or a mode of using e.g. the at least one second light emitting element as turn signal light.

In an exemplary embodiment, the at least one electrical contact element is electrically connected with the at least one first light emitting element and/or the at least one second light emitting element by means of a lead frame. In an exemplary embodiment, a lead frame corresponds to or comprises a metal structure, in particular a metal structure embedded in the lighting device, being configured for carrying electrical power from a power source to the at least one first light emitting element and/or the at least one second light emitting element via the at least one electrical contact element. In other words, in an exemplary embodiment, the lead frame serves for electrically connecting the lighting device to a power source. Using a lead frame, in particular a metal lead frame embedded in the lighting device, for electrically connecting the at least one electrical contact element with the at least one first light emitting element and/or the at least one second light emitting element enables a compact architecture and enhanced thermal conductivity.

In an exemplary embodiment, the automotive lighting system corresponds to or comprises an automotive daylight running system, an automotive autonomous driving indication system, an automotive turn signal lighting system and/or an automotive headlight lighting system. Thereby, such automotive lighting system comprises necessary components including e.g. a controller for controlling power supply to the at least one first and/or the at least one second light emitting element, the controller being a separate component and/or integrated in an automotive control system for controlling further functions.

In an exemplary embodiment, the automotive lighting system further comprises at least one optical element configured for shaping a beam of light emitted from the at least one first light emitting element and the at least one second light emitting element.

Shaping a beam of light is to be understood as adjusting for example a direction, intensity, shape or pattern of a beam of light emitted from the at least one first and/or the at least one second light emitting element. Shaping a beam of light emitted from each of the at least one first light emitting element and the at least one second light emitting element with at least one common optical element advantageously supports use of the at least one first light emitting element and the at least one second light emitting element in the automotive lighting system in the at least two predetermined modes of operation. In an exemplary embodiment, the at least one optical element comprises one or more reflectors and/or lens elements. For example, one or more lens elements may be incorporated in an outer glass portion through which the beam of light is outwards.

In an exemplary embodiment, the automotive lighting system further comprises a controller configured to respectively control the at least one first and/or the at least one second light emitting element to be turned ON and/or OFF in accordance with at least one predetermined mode of operation. As mentioned, the controller may be a separate controller or may be a subcomponent of a control system. The controller may correspond to a suitable dedicated controller or may correspond to or be comprised by a microprocessor.

In an exemplary embodiment, the predetermined mode of operation comprises at least one of: a daytime running mode wherein the first color is a white color and according to which the at least one first light emitting element is turned ON and the at least one second light emitting element is turned OFF; a turn-signal mode wherein the second color is an amber color and according to which the at least one second light emitting element is, in particular periodically, turned ON and OFF and the at least one first light emitting element is turned OFF; a first autonomous driving mode wherein the first color is a cyan color and according to which the at least one first light emitting element is turned ON and the at least one second light emitting element is turned OFF; a second autonomous driving mode wherein the second color is a cyan color and according to which the at least one first light emitting element is turned OFF and the at least one second light emitting element is turned ON.

Accordingly, in an exemplary embodiment, the lighting device comprises at least one first light emitting element configured to emit either light of a white color (e.g. for use in the daytime running mode) and/or light of a cyan color (e.g. for use in the first autonomous driving mode), and at least one second light emitting element configured to emit either light of an amber color (e.g. for use in the turn signal mode) or light of a cyan color (e.g. for use in the second autonomous driving mode).

For example, when used as daytime running light or when used in the first autonomous driving mode, the at least one first light emitting element is turned ON, whereby the at least one second light emitting element is turned OFF. As a further example, in turn signal mode, the at least one first light emitting element may be turned OFF, and the at least one second light emitting element may be (e.g. periodically) turned ON and OFF to indicate a turn of a vehicle. As a further example, in the second autonomous driving mode, the at least one first light emitting element may be turned OFF, and the at least one second light emitting element may be turned ON to indicate that the vehicle is driving autonomously.

In an exemplary embodiment, the automotive lighting system further comprises a heatsink, whereby the interface layer is arranged in contact, in particular in direct mechanical contact, with the heat sink for guiding heat generated by the at least one first light emitting element and/or the at least one second light emitting element to the heatsink. This advantageously enables an enhanced heat management of the automotive lighting system and in particular the lighting device included in it.

The features and example embodiments of the invention described above may equally pertain to the different aspects according to the present invention. In particular, with the disclosure of features relating to the lighting device according to the first aspect, also corresponding features relating to the automotive lighting system according to the second aspect or to the method according to the third aspect are disclosed.

It is to be understood that the presentation of embodiments of the invention in this section is merely exemplary and non-limiting.

Other features of the present invention will become apparent from the following detailed description considered in conjunction with the accompanying drawings. It is to be understood, however, that the drawings are designed solely for purposes of illustration and not as a definition of the limits of the invention, for which reference should be made to the appended claims. It should be further understood that the drawings are not drawn to scale and are merely intended to conceptually illustrate the structures and procedures described herein.

### BRIEF DESCRIPTION OF THE DRAWINGS

Examples of the invention will now be described in detail with reference to the accompanying drawings, in which:
- Fig. 1A: exemplarily illustrates a lighting device according to an embodiment of the invention;
- Fig. 1B: illustrates an exemplary circuit diagram of the lighting device of Fig. 1A;
- Fig. 1C: illustrates an exemplary circuit diagram of the lighting device of Fig. 1A;
- Fig. 2A: exemplarily illustrates a lighting device according to an embodiment of the invention; and
- Fig. 2B: illustrates an exemplary circuit diagram of the lighting device of Fig. 2A.

### DETAILED DESCRIPTION OF THE EMBODIMENTS

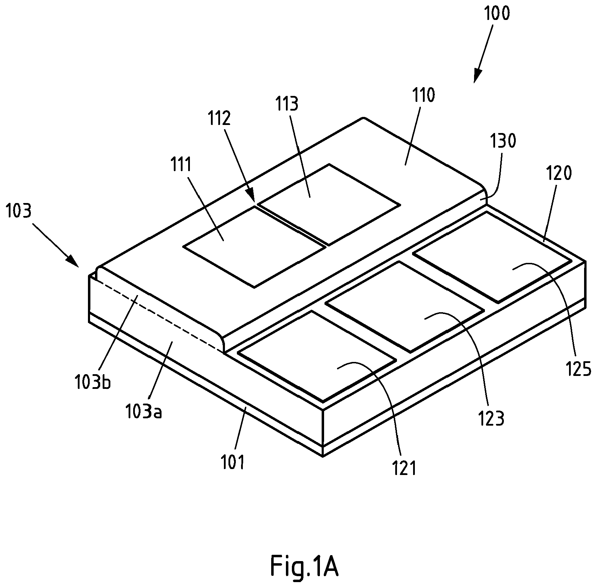

Fig. 1A shows a lighting device 100 comprising an interface layer 101 and an electrically insulating layer 103 arranged on the interface layer 101. The lighting device 100 further comprises a mounting portion 110 comprising respective portions of the interface layer 101 and the electrically insulating layer 103. A first light emitting element 111 and a second light emitting element 113 are mounted to the mounting portion 110, thereby mechanically adjusting their respective positions within the lighting device 100. A gap 112 is provided in between the first and second light emitting elements 111, 113.

Further, electrically insulating layer 103 comprises a supporting portion 103a and a covering portion 103b. While supporting portion 103a advantageously provides the overall mechanical stability of lighting device 100, covering portion 103b protects first light emitting element 111 and second light emitting element 113 against environmental conditions such as dust or humidity and enhances heat dissipation by increasing the contact area of the first and second light emitting element 111, 113 with electrically insulating layer 103.

The lighting device 100 further comprises a connection portion 120 also comprising respective portions of the interface layer 101 and the electrically insulating layer 103. Connection portion 120 further comprises electrical contact elements 121, 123, 125, thereby allowing for electrically connecting the lighting device 100 to a power supply (not shown). The electrical contact elements 121, 123, 125 are respectively in electrical contact with the first and second light emitting elements 111, 113 via a lead frame which is embedded in interface layer 101 and electrically insulating layer 103 and therefore not visible in the figures. As can be taken from the figure, a thickness of the connection portion 120 is smaller than a thickness of the mounting portion 110, and the connection portion 120 and the mounting portion 110 are arranged mutually adjacent, thereby forming a step 130 at a transition from the connection portion 120 to the mounting portion 110.

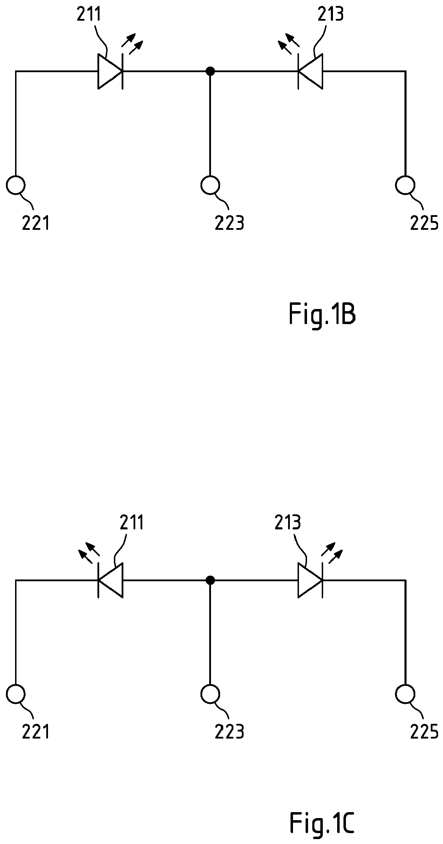

Fig. 1B shows an exemplary circuit diagram which illustrates an example of electrically connecting the lighting device 100. Reference numerals 211 and 213 denote the first light emitting element 111 and the second light emitting element 113 of Fig. 1A in this circuit diagram. The light emitting element are electrically connected to a power source (not shown) by electrical contact elements 221, 223, 225, thereby allowing for carrying electrical power from the power source to the first light emitting element 211 and the second light emitting element 213. It is noted that electrical contact element 223 is electrically connected to both the first light emitting element 211 and the second light emitting element 213. Fig. 1C shows the circuit diagram of Fig. 1B where a direction of an electrical current is reversed as indicated by a direction illustrated by light emitting elements 211, 213.

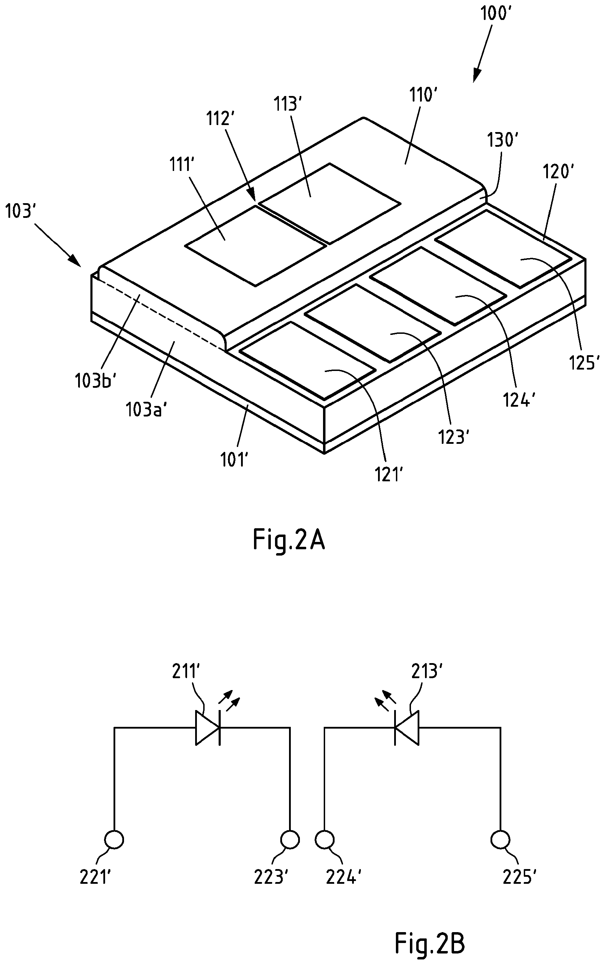

Fig. 2A shows a lighting device 100' comprising an interface layer 101' and an electrically insulating layer 103' arranged thereon. The lighting device 100' further comprises a mounting portion 110' comprising respective portions of the interface layer 101' and the electrically insulating layer 103'. First and second light emitting elements 111' and 113' are mounted to the mounting portion 110', whereby a gap 112' is formed in between the first and second light emitting elements 111', 113'. Electrically insulating layer 103' comprises a supporting portion 103a' and a covering portion 103b' offering the same advantages as described above for Fig. 1A.

The lighting device 100' further comprises a connection portion 120' comprising respective portions of the interface layer 101' and the electrically insulating layer 103'. Connection portion 120' comprises electrical contact elements 121', 123', 124', 125', thereby allowing for electrically connecting the lighting device 100' to a power supply. A thickness of the connection portion 120' is smaller than a thickness of the mounting portion 110', and the connection portion 120' and the mounting portion 110' are arranged mutually adjacent, thereby forming a step 130' at a transition from the connection portion 120' to the mounting portion 110'.

Fig. 2B shows an exemplary circuit diagram which may be used for electrically connecting the lighting device 100'. A first light emitting element 211' and a second light emitting element 213' are electrically connected to a power source (not shown) by electrical contact elements 221', 223', 224', 225', thereby allowing for carrying electrical power from the power source to the first light emitting element 211' and the second light emitting element 213'.

### LIST OF REFERENCE SIGNS:

| | |
|---|---|
| Lighting device | 100, 100' |
| Interface layer | 101, 101' |
| Electrically insulating layer | 103, 103' |
| Supporting portion | 103a, 103a' |
| Covering portion | 103b, 103b' |
| Mounting portion | 110, 110' |
| First light emitting element | 111, 111', 211, 211' |
| Gap | 112, 112' |
| Second light emitting element | 113, 113', 213, 213' |
| Connection portion | 120, 120' |
| Electrical contact element | 121, 123, 125, 121', 123', 124', 125', 221, 223, 225, 221', 223', 224', 225' |
| Step | 130, 130' |

## Claims

1. A lighting device (100, 100') comprising:
- an electrically insulating layer (103, 103');
- at least one first light emitting element (111, 111', 211, 211') configured to emit light of a first color, and at least one second light emitting element (113, 113', 213, 213') configured to emit light of a second color, the at least one first light emitting element (111, 111', 211, 211') and the at least one second light emitting element (113, 113', 213, 213') being arranged on the electrically insulating layer (103, 103'); and
- at least one electrical contact element (121, 123, 125, 121', 123', 124', 125', 221, 223, 225, 221', 223', 224', 225');
- wherein the at least one electrical contact element (121, 123, 125, 121', 123', 124', 125', 221, 223, 225, 221', 223', 224', 225') is arranged at least in part on the electrically insulating layer (103, 103') and is electrically connected to the at least one first light emitting element (111, 111', 211, 211') and/or to the at least one second light emitting element (113, 113', 213, 213').

2. The lighting device (100, 100') according to claim 1, further comprising an interface layer (101, 101'), the electrically insulating layer (103, 103') being arranged on the interface layer (101, 101').

3. The lighting device (100, 100') according to claims 1 or 2, wherein the first color is different from the second color, wherein the first and/or the second color are selected from:
• a white color;
• an amber color;
• a cyan color.

4. The lighting device (100, 100') according to any of the preceding claims, further comprising a connection portion (120, 120') for electrically connecting the lighting device (100, 100') and a mounting portion (110, 110') for mounting the at least one first light emitting element (111, 111', 211, 211') and the at least one second light emitting element (113, 113', 213, 213'), wherein a thickness of the connection portion (120, 120') is smaller than a thickness of the mounting portion (110, 110').

5. The lighting device (100, 100') according to claim 4, wherein the mounting portion (110, 110') and the connection portion (120, 120') are arranged mutually adjacent forming a step (130, 130') at a transition from the connection portion (120, 120') to the mounting portion (110, 110').

6. The lighting device (100, 100') according to any of claims 4 or 5, wherein the at least one first light emitting element (111, 111', 211, 211') and the at least one second light emitting element (113, 113', 213, 213') are respectively received at least in part inside of the mounting portion (110, 110').

7. The lighting device (100, 100') according to any of claims 4 to 6, wherein the at least one electrical contact element (121, 123, 125, 121', 123', 124', 125', 221, 223, 225, 221', 223', 224', 225') comprises an essentially planar contact portion and is arranged on the electrically insulating layer (103, 103') within the connection portion (120, 120').

8. The lighting device (100, 100') according to any of the preceding claims, wherein the at least one first light emitting element (111, 111', 211, 211') and the at least one second light emitting element (113, 113', 213, 213') are arranged adjacent to each other, such that respective light emission surfaces of the at least one first (111, 111', 211, 211') and the at least one second light emitting element (113, 113', 213, 213') are arranged in a common plane.

9. The lighting device (100, 100') according to any of the preceding claims, wherein the lighting device (100, 100') comprises at least three electrical contact elements (121, 123, 125, 121', 123', 124', 125', 221, 223, 225, 221', 223', 224', 225'), two of which are respectively electrically connected with a corresponding one of the at least one first (111, 111', 211, 211') and the at least one second light emitting element (113, 113', 213, 213'), and wherein one of the at least three electrical contact elements (121, 123, 125, 121', 123', 124', 125', 221, 223, 225, 221', 223', 224', 225') is electrically connected to both of the at least one first light emitting element (111, 111', 211, 211') and the at least one second light emitting element (113, 113', 213, 213').

10. The lighting device (100, 100') according to any of the preceding claims, wherein the lighting device (100, 100') comprises at least a first, a second, a third and a fourth electrical contact element (121, 123, 125, 121', 123', 124', 125', 221, 223, 225, 221', 223', 224', 225'), wherein the at least one first light emitting element (111, 111', 211, 211') is electrically connected to the first and the second contact element (121, 123, 125, 121', 123', 124', 125', 221, 223, 225, 221', 223', 224', 225'), and wherein the at least one second light emitting element (113, 113', 213, 213') is electrically connected to the third and the fourth contact element (121, 123, 125, 121', 123', 124', 125', 221, 223, 225, 221', 223', 224', 225').

11. Automotive lighting system, in particular headlight, comprising the lighting device (100, 100') according to any of the preceding claims.

12. The automotive lighting system according to claim 11, further comprising
- at least one optical element configured for shaping a beam of light emitted from the at least one first light emitting element (111, 111', 211, 211') and the at least one second light emitting element (113, 113', 213, 213').

13. The automotive lighting system according to any of claims 11 or 12, further comprising
- a controller configured to respectively control the at least one first (111, 111', 211, 211') and/or the at least one second light emitting element (113, 113', 213, 213') to be turned ON and/or OFF in accordance with at least one predetermined mode of operation.

14. The automotive lighting system according to any of claims 11 to 13, wherein the predetermined mode of operation comprises at least one of:
- a daytime running mode wherein the first color is a white color and according to which the at least one first light emitting element (111, 111', 211, 211') is turned ON and the at least one second light emitting element (111, 111', 211, 211') is turned OFF;
- a turn-signal mode wherein the second color is an amber color and according to which the at least one second light emitting element (113, 113', 213, 213') is, in particular periodically, turned ON and OFF and the at least one first light emitting element (111, 111', 211, 211') is turned OFF;
- a first autonomous driving mode wherein the first color is a cyan color and according to which the at least one first light emitting element (111, 111', 211, 211') is turned ON and the at least one second light emitting element (113, 113', 213, 213') is turned OFF;
- a second autonomous driving mode wherein the second color is a cyan color and according to which the at least one first light emitting element (111, 111', 211, 211') is turned OFF and the at least one second light emitting element (113, 113', 213, 213') is turned ON.

15. Method for producing a lighting device (100, 100'), in particular according to any of claims 1 to 10, the method comprising:
- providing an electrically insulating layer (103, 103');
- providing at least one first light emitting element (111, 111', 211, 211') configured to emit light of a first color, and at least one second light emitting element (113, 113', 213, 213') configured to emit light of a second color, the at least one first light emitting element (111, 111', 211, 211') and the at least one second light emitting element (113, 113', 213, 213') being arranged on the electrically insulating layer (103, 103'); and
- providing at least one electrical contact element (121, 123, 125, 121', 123', 124', 125', 221, 223, 225, 221', 223', 224', 225');
- wherein the at least one electrical contact element (121, 123, 125, 121', 123', 124', 125', 221, 223, 225, 221', 223', 224', 225') is arranged at least in part on the electrically insulating layer (103, 103') and is electrically connected to the at least one first light emitting element (111, 111', 211, 211') and/or to the at least one second light emitting element (113, 113', 213, 213').
